# EUROPEAN PATENT APPLICATION

(11) **EP 4 757 541 A1**
(43) Date of publication of application: **10.06.2026**
(21) Application number: 24217795.4
(22) Date of filing: 05.12.2024
(51) Int. Cl.: H10F 30/22, H10F 77/14, H10F 77/40, G02B 6/42

(54) **A 2D MATERIAL PHOTONIC-PLASMONIC PHOTODETECTOR**

(71) Applicant: ETH Zurich, 8092 Zurich (CH)
(72) Inventor: LEUTHOLD, Jürg, 8173 Neerach (CH); FEDORYSHYN, Yuriy, 8037 Zürich (CH); KÖPFLI, Stefan, 5712 Beinwil am See (CH); BAUMANN, Michael, 8051 Zürich (CH); RIEBEN, Daniel, 8052 Zürich (CH)

(57) **Abstract**

A photodetector (PD), comprises: a photonic layer (1) which includes a widening section (12) followed by a wide section (13), wherein the widening section (12) is configured to receive an optical signal (oS) and to distribute optical power of the optical signal (oS) to the wide section (13); a spacer layer (2) which is in contact with the wide section (13); a 2D material layer (3) which is in contact with the spacer layer (2); a plasmonic layer (4) which is in contact with the 2D material layer (3) and includes a plurality of plasmonic resonators (411, 421) which are connected via contact lines (412, 422) to connector lines (413, 423), wherein the connector lines (413, 423) enable to measure charge carriers which are generated upon receipt of the optical signal (oS).

## Description

### FIELD OF THE INVENTION

The present invention relates to a 2D material photonic-plasmonic photodetector. In particular, the present invention relates to a 2D material photonic-plasmonic photodetector operating at infrared wavelengths. In particular, the present invention relates to a high-speed and highly responsive 2D material photonic-plasmonic photodetector.

### BACKGROUND ART

Photodetectors convert a signal from an optical domain into an electrical domain. The majority of photodetectors absorb an optical signal of a specific wavelength range and convert the absorbed optical signal in part into charge carriers. The charge carriers can be detected by electrically measuring a change of a voltage or a current. Photodetectors have applications in data communications. The ever-increasing demand for higher data traffic due to e.g. complex internet services, etc. requires novel schemes to increase the capacity of today's fiber links. One solution to fulfill this need is spectral- and space-division multiplexing. Therefore, there is a need for novel components which can operate over a large spectral range, have a high bandwidth, and can be densely integrated on a single chip at low costs. Additionally, these components must be compatible with other platforms for more complex detection schemes such as I/Q detection (I/Q: in-phase and quadrature components) for maximum spectral efficiency.

In data communication, infrared photodetectors are widely used which operate at an infrared wavelength. Most implementations of infrared photodetectors rely on semiconductor devices. They operate by using a bandgap of an active material to absorb the optical signal, wherein a bias voltage is applied to the active material in order to extract charge carriers generated by the absorption of the optical signal. Typically, these devices rely on expensive crystalline materials that are difficult to manufacture and integrate. Efficient and high-speed performance is determined by the semiconductor material. Further, they have a trade-off between active area size, saturation power and bandwidth.

2D materials belong to the class of nanomaterials. Nanomaterials can be broadly classified by the total number of their nanoscopic dimensions. If all three dimensions of a material are nano-sized, it would be called a 0D (zero-dimensional) material, more commonly known as a nanoparticle. If two dimensions of a material are nano-sized, with the other dimension much larger (much like a piece of string shrunk down to a tiny size), then this is a 1D material or 'nanotube/nanowire'. If only one dimension is nano-sized, it would be a 2D material - resembling a large, but very thin sheet (like a piece of paper). Finally, if a material does not have any dimensions that are small enough to be considered nano-sized, then it is not a nanomaterial. Instead, it should be referred to as a 'bulk' material.

2D materials have the potential to enable required specifications of photodetectors. Yet, two factors keep them from reaching their potential: (1) the low volume of 2D materials combined with typical device design leads to an early saturation onset effectively limiting the maximum signal that is achievable; (2) the large surface to volume ration leads to device to device variation making it difficult to create more complex circuits.

S. M. Koepfli et al., >500 GHz Bandwidth Graphene Photodetector Enabling Highest-Capacity Plasmonic-to-Plasmonic Links, 2022 European Conference on Optical Communication (ECOC), Basel, Switzerland, 2022, pp. 1-4 discloses a metamaterial enhanced graphene photodetector. Graphene is placed in a metamaterial perfect absorber (MPA). High-speed operation under near-infrared illumination is enabled by combining an interconnected resonator MPA with graphene. Alternating contact metals in the resonator layer enable zero-bias operation.

P. Ma et al, Plasmonically Enhanced Graphene Photodetector Featuring 100 Gbit/s Data Reception, High Responsivity, and Compact Size, ACS Photonics 2019 6 (1), 154-161 discloses a plasmonic enhanced graphene photodetector with >100 GHz bandwidth. Graphene is placed on a silicon photonic waveguide and gold plasmonic resonators are placed on top. High responsivity with a low saturation power is observed.

### DISCLOSURE OF THE INVENTION

There may be a need for a photodetector which does not have disadvantages of the prior art. In particular, there may be a need for a photodetector which enables high-speed and high responsiveness at the same time.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to a photodetector, comprising: a photonic layer which includes a widening section followed by a wide section, wherein the widening section is configured to receive an optical signal and to distribute optical power of the optical signal to the wide section, a 2D material layer which is arranged between the wide section and a plasmonic layer which is in contact with the 2D material layer and includes a plurality of plasmonic resonators which are connected via contact lines to connector lines, wherein the connector lines enable to measure charge carriers which are generated upon receipt of the optical signal.

The photodetector can have the form of a vertical stack of layers. The photonic layer can be arranged on top of a substrate. The spacer layer can be arranged on top of the photonic layer. The 2D material layer can be arranged on top of the spacer layer. The plasmonic layer can be arranged on the 2D material layer. The optical signal can be received in a horizontal direction by the widening section, which distributes the optical signal to the wide section. The optical signal interacts via the spacer layer and the 2D material layer with the plasmonic layer arranged on top of the wide section, wherein charge carriers are generated in the 2D material layer and extracted by the plasmonic layer (the skilled person describes this also as charge carriers generated in the active material or in the active area). The charge carriers can be detected at the connector lines. The wide section is configured to receive optical power from the widening section and to transmit optical power to the plasmonic layer.

2D materials offer a low-cost alternative to existing high-speed technologies. Because of the low volume, absorption of light is typically low. Photonic integrated circuit approaches confine the light to a small volume, which increases absorption at the cost of an early onset saturation and a limit in maximum extractable photo response. In the prior art, the active area of the photodetector is kept small, because the larger area typically leads to reduced speed. According to the present invention, the volume of the active medium is increased, as the optical signal is spread out over an area rather than along a line. Accordingly, larger signals are achieved. To counteract the loss in speed, the present invention includes interconnected plasmonic structures, which in combination with the widened photonic integrated circuit has the advantages of: (1) increase of the otherwise low absorption in the 2D material and control of the spatial absorption distribution within the channel; (2) the plasmonic resonators are interconnected and serve as electrodes, which enables small carrier extraction pathways thereby enabling highest operation speeds; (3) the plasmonic resonators further act as dopants that enable the passive operation of the device, which can be enabled by employing alternating contact metals for the plasmonic resonators; (4) as described below, a passivation layer can ensure a stable operation in air, and a top gate layer can serve as a third terminal which allows to fine tune performance of the device.

The combination of optical and electrical engineering of the architecture according to the present invention with 2D materials enables unprecedented performance characteristics. As described in more detail below, structuring and alignment of the 2D material layer, the plasmonic layer, passivation layer, top gate layer and connector pads can be optimized to remove parasitic electrical characteristics that would lower the absolute bandwidth of the device.

As described in more detail below, several photodetectors according to the present invention combined with corresponding photonic integrated circuit elements enable more complex receivers, for example a coherent receiver, etc. In combination with a top gate layer as described below, an imbalance tunable device can be achieved, which is not possible with devices according to the prior art. Furthermore, the high bandwidth of the photodetector according to the present invention allows co-integration with on-chip antennas to create sub-THZ sources, wherein connector pads as described below can be missing, free-space radiation can be achieved, etc.

In an embodiment, a spacer layer is in contact with the wide section and the 2D material layer. The spacer layer can be arranged between the wide section and the 2D material layer. The spacer layer can serve as substrate to the 2D material layer. The thickness and material of the spacer layer can influence the properties of the optical field and the interaction with the 2D material and plasmonic resonators. The spacer layer can further enhance the performance of the 2D material layer, which can be used to enhance the carrier generation and extraction. Depending on the photonic layer material, i.e., the photonic waveguide material, the 2D material can also be placed directly onto the photonic layer without the need of a spacer layer.

A photodetector according to the present invention can achieve bandwidths in excess of 300 GHz. Damage threshold is increased and operation with increased optical power is enabled to extract higher photocurrents. Spectral broadband operation beyond classical telecom wavelengths with the same bandwidths is enabled. Fast passive operation is enabled (i.e., no electrical biasing). 2D materials are cheap. The photodetector does not need to be on a dedicated growth substrate, which simplifies fabrication, cost, footprint, etc.

For example, the photodetector can include a narrow section which is configured to receive an optical signal from a standard optical signal line for optical communication and to transmit the optical signal to the widening section.

The change from a typical single mode waveguide to the wide section where the active area with the plasmonic resonators is situated can be achieved by a variety of transitions as described in more detail below.

In an embodiment, one or more of the plasmonic resonators, the contact lines and the connector lines include a lower layer which is in contact with the 2D material layer and an upper layer which is in contact with the lower layer, wherein a material of the lower layer differs from a material of the upper layer. Any combination of materials can be provided. Performance can be improved. The upper layer can be used to control the targeted generation of the plasmonic resonance. The upper layer can be used as a protection layer for the lower layer. The lower layer can be used to optimize the contact resistance. The lower layer can be used to controllably dope the 2D material. The combination of 2D material, lower layer and upper layer can be used to form an electrical junction or barrier.

In an embodiment, the plasmonic resonators and/or the contact lines have an alternating configuration. Dopants can be enabled, for example to enable passive operation.

In an embodiment, the 2D material layer includes one or more layers of a 2D material. Performance can be improved. Multiple layers of various 2D materials can be used to increase the performance of the photodetector, leading to better absorption, carrier extraction or faster response. The 2D material layer stack can be partially removed such that the plasmonic layer is in contact with all or some of the 2D material layers.

In an embodiment, the 2D material layer includes a 2D material selected from one or more of a graphene, a semiconducting material, a Vand Der Waals heterostructure material, and a semimetal material.

In an embodiment, the plasmonic layer is in contact with a passivation layer. Stable operation in air can be achieved.

In an embodiment, the passivation layer is in contact with a top gate layer. The top gate layer can include a single continuous film, or can be separated into multiple sections which can be individually contacted. Performance and yield can be improved. Operation mechanism or conditions can be controlled.

In an embodiment, a mirror element is arranged which follows the wide section and which is configured to reflect optical power back to the wide section. Performance can be improved. Size can be reduced.

In an embodiment, a 2D material insulator is arranged between the spacer layer and the 2D material layer.

In an embodiment, the plasmonic resonators include elements which have different geometries. For example, the geometries of the resonators can be selected such that absorption in multiple bands is achieved, e.g., 1310nm and 1550nm operation can be enabled. For example, asymmetric geometries can be used at the first and second contact lines. The resonators can be arranged in an apodised manner, wherein the resonators can also be rotated. Resonator shapes can include, but are not limited to the likes of square, rectangular, circular, dipole, elliptical, triangular, disc sector, ring, ring sector, bow tie, four-leaf clover, etc.

In an embodiment, a 2D material insulator is in contact with the 2D material layer in a configuration which enables that the 2D material layer remains in contact with the plasmonic layer. For example, the 2D material insulator can be arranged on top of the 2D material layer.

In an embodiment, the photodetector includes contact lines without plasmonic resonators.

In an embodiment, the widening section is formed by one or more elements having the form of one or more of a trapezoid, a rectangle, an arbitrary form. Distribution of optical power to the wide section depends on the selected elements and their geometries.

In an embodiment, the photodetector further includes one or more inductive elements which are connected to the connector lines. The inductive elements can be connected to the connector lines or the connector pads as described below. Frequency response can be tuned. Inductive peaking can be achieved.

In an embodiment, the photodetector further includes a bias tee. The bias tee can include one or more inductors which can be connected to the connector lines or the connector pads as described below and/or the top gate layer. The bias tee can include one or more capacitors which can be formed between the top gate layer and the connector lines or the connector pads as described below. High frequency can be separated from DC.

The invention also relates to two photodetectors connected to a common connector pad. An on-chip subtraction architecture is enabled. A balanced detector is enabled.

The invention also relates to an apparatus comprising one or more photodetectors.

In an embodiment, the apparatus is configured to provide an I/Q detector or a balanced detector.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 schematically shows a top view of a photodetector according to the present invention.
Fig. 1A schematically shows a cross-section of the photodetector shown in Fig. 1.
Fig. 2 schematically shows a top view of a photodetector according to the present invention having arranged connector pads.
Fig. 3 schematically shows a cross-section of a photodetector according to the present invention having arranged a passivation layer and a top gate layer.
Fig. 4a schematically shows a top view of a plasmonic layer of a photodetector according to the present invention having contact lines without plasmonic resonators.
Fig. 4b schematically shows a cross-section of a plasmonic layer of a photodetector according to the present invention having plasmonic resonators with alternating configurations.
Fig. 5 schematically shows a top view of a widening section followed by a wide section being in contact with a 2D material layer and a plasmonic layer.
Fig. 6 schematically shows an I/Q detector having arranged four photodetectors according to the present invention and a photonic hybrid.
Fig. 6A schematically shows a cross-section of the four photodetectors shown in Fig. 6.
Fig. 7 schematically shows a top view of a photodetector according to the present invention having arranged connection lines implementing inductors.
Fig. 7A schematically shows a cross-section of the photodetector shown in Fig. 7 implementing a capacitor.
Fig. 8 schematically shows a top view of a photodetector according to the present invention including inductors and capacitors.
Fig. 9 schematically shows a top view of a balanced detector having arranged two photodetectors according to the present invention.
Fig. 10a-f schematically show embodiments of widening sections of photodetectors according to the present invention.
Fig. 10e A schematically shows a cross-section of the photodetector shown in Fig. 10e.
Fig. 11 schematically shows a photodetector according to the present invention having arranged a plurality of plasmonic layers in a horizontal and vertical direction.
Fig. 11A schematically shows a cross-section of the photodetector shown in Fig. 11.
Fig. 11B schematically shows a cross-section of a photodetector with a plurality of plasmonic layers in a vertical direction.
Fig. 12 schematically shows a top view of a photodetector according to the present invention.
Fig. 12A schematically shows a cross-section of the photodetector shown in Fig. 12.

The figures are only schematic and not to scale. Same reference signs refer to same or similar features.

### MODE(S) FOR CARRYING OUT THE INVENTION

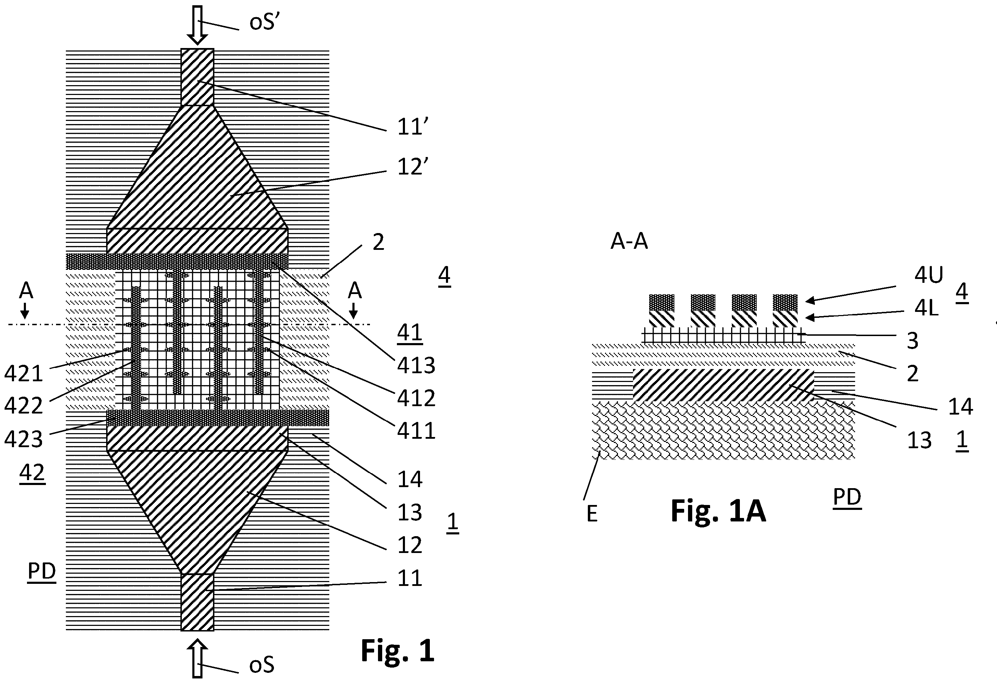

Fig. 1 schematically shows a top view of a photodetector PD according to the present invention. The photodetector PD includes a photonic layer 1 which includes a widening section 12 followed by a wide section 13. The widening section 12 is configured to receive an optical signal oS and to distribute optical power of the optical signal oS to the wide section 13.

The term "followed" relates to the direction of propagation of the optical signal oS.

In some embodiments, as shown in Fig. 1, the widening section 12 can be configured to receive the optical signal oS via a narrow section 11 arranged at the photodetector PD.

In some embodiments, as shown in Fig. 1, the photonic layer 1 can include a photonic cladding 14 which is arranged adjacent to the narrow section 11, the widening section 12 and the wide section 13.

Thus, the photonic layer 1 according to Fig. 1 includes a narrow section 1 followed by a widening section 12 followed by a wide section 13 and a photonic cladding 14 connected to them.

Fig. 1A schematically shows cross-section A-A of the photodetector shown in Fig. 1. The cross-section A-A shown in Fig. 1 is within the wide section 13 and orthogonal to the propagation of the optical signal oS. The wide section 13 is in contact with a spacer layer 2. A 2D material layer 3 is in contact with the spacer layer 2. A plasmonic layer 4 is in contact with the 2D material layer 3. As shown in Fig. 1, the plasmonic layer includes a plurality of plasmonic resonators 411, 421. The plasmonic resonators 411, 421 are connected via contact lines 412 422 to connector lines 413, 423. The connector lines 413, 423 enable to measure charge carriers which are generated upon receipt of the optical signal oS.

The spacer layer 2 is optional.

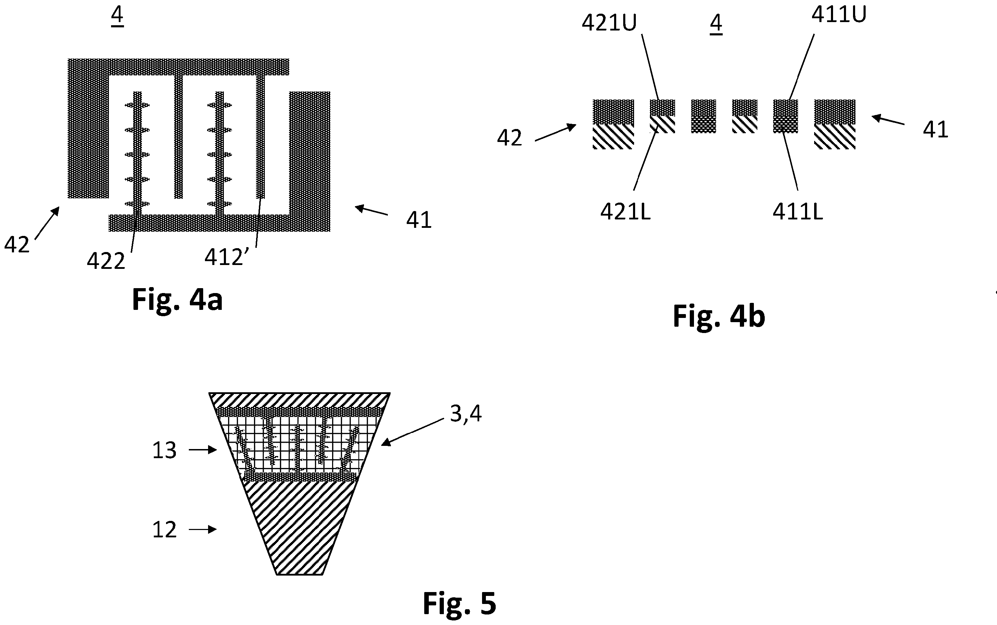

Fig. 1 shows a first structure 41 which includes first plasmonic resonators 411 connected via first contact lines 412 to a first connector line 413, and a second structure 42 which includes second plasmonic resonators 421 connected via second contact lines 422 to a second connector line 423. The locations of the plasmonic resonators 411, 421 have the form of a matrix. The first contact lines 412 are parallel to each other. The second contact lines 422 are parallel to each other. However, as shown in Fig. 5 below, the contact lines 412, 422 do not have to be parallel to each other. The first contact lines 412 and the second contact lines 422 are alternating in a horizontal direction. The first structure 41 and the second structure 42 are electrically isolated from each other.

The layout of the plasmonic resonators 411, 421 can be adapted to a variety of designs, however need to serve as electrodes to enable high operation speed.

In some embodiments, as shown in Fig. 1, the wide section 13 can be followed by a further widening section 12' and a further narrow section 11'. For example, the optical signal oS that is not absorbed by the photodetector can be monitored. A further optical signal oS' can be received via the further narrow section 11'. The further widening section 12' can distribute optical power of the further optical signal oS' to the wide section 13. A more uniform illumination can be achieved. The optical signal oS received by the narrow section 11 and the further optical signal oS' received by the further narrow section 11' can relate to the same optical signal.

The term "widening" describes that the optical power is distributed or widened, and the term "tapering" describes that optical power is combined or condensed. The term "widening" describes a cross-section which gets wider in a direction of propagation, and the term "tapering" describes a cross-section which gets narrower in a direction of propagation.

In some embodiments, as shown in Fig. 1A, the photonic layer 1 can be in contact with a substrate E. The photodetector PD can include a vertical stack of layers, wherein the photonic layer 1 is arranged on top of the substrate E, wherein the spacer layer 2 is arranged on top of the photonic layer 1, wherein the 2D material layer 3 is arranged on top of the spacer layer 2, and wherein the plasmonic layer 4 is arranged on top of the 2D material layer 3.

In some embodiments, as shown in Fig. 1A, the plasmonic layer 4 can include a lower plasmonic layer 4L and an upper plasmonic layer 4U formed from different materials.

In some embodiments, the contact lines 412, 422 are in-plane with the plasmonic resonators 411, 421. In other embodiments, the contact lines 412, 422 and the plasmonic resonators 411, 421 are arranged at different planes (contact lines are out of plane of the plasmonic resonators).

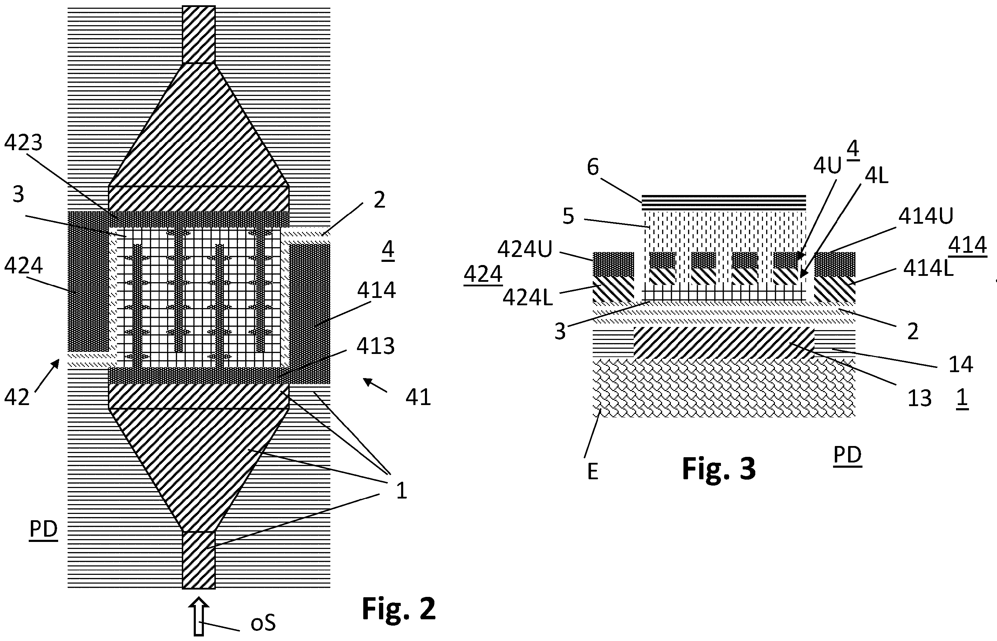

Fig. 2 schematically shows a top view of a photodetector PD according to the present invention having arranged connector pads 414, 424 at the connector lines 413, 423 of the plasmonic structures 41, 42. The connector pads 414, 424 can be configured to simplify electrically accessing the photodetector PD, for example by wire bonding, etc.

Fig. 3 schematically shows a cross-section of a photodetector PD according to the present invention having arranged a passivation layer 5 and a top gate layer 6. The passivation layer 5 is in contact with the plasmonic layer 4. The top gate layer 6 is in contact with the passivation layer 5. The plasmonic layer 4 and the passivation layer 5 and the top gate layer 6 form a vertical stack. The top gate layer 6 can enable an increase in performance and yield of the photodetector PD.

In some embodiments, as shown in Fig. 3, the connector pads 414, 424 can include an upper layer 414U, 424U and a lower layer 414L, 424L formed from different materials. Furthermore, the connector lines can also include an upper layer and a lower layer formed from different materials.

Fig. 4a schematically shows a top view of a plasmonic layer 4 of a photodetector according to the present invention having contact lines without plasmonic resonators. The first contact lines 412 do not have arranged plasmonic resonators, and the second contact lines 422 have arranged plasmonic resonators. For example, the plasmonic resonators and contact lines can be fabricated in a single metal layer (without alternating metals), wherein plasmonic resonators are only present on every other line. This simplifies fabrication at the cost of a slightly decreased performance.

Fig. 4b schematically shows a cross-section of a plasmonic layer 4 of a photodetector according to the present invention having plasmonic resonators with alternating configurations. The lower layer of the first plasmonic resonators 411L and the lower layer of the second plasmonic resonators 421L are formed from different materials. The upper layer of the first and second plasmonic resonators 411U, 421U are formed from the same material.

Typically, the plasmonic resonators 411, 421 and the contact lines 412, 422 have the same thickness. The connector lines 413, 423 and/or the connector pads 414, 424 can have a thickness which differs from the thickness of the plasmonic resonators 411, 421 and the contact lines 412, 422. For example, in one fabrication step the plasmonic resonators 411, 421, the contact lines 412, 422 and one part of the connector lines 413, 423/connector pads 414, 424 can be arranged, and in a further fabrication step a further part of the connector lines 413, 423/connector pads 414, 424 can be arranged.

Fig. 5 schematically shows a top view of a widening section 12 followed by a wide section 13 being in contact with a 2D material layer 3 and a plasmonic layer 4. The widening section 12 and the wide section 13 have the form of a trapezoid. As shown in Fig. 5, the orientation of the contact lines and the plasmonic resonators of the plasmonic layer 4 are adapted to the form of the wide section 13. Thus, the contact lines are not parallel to each other.

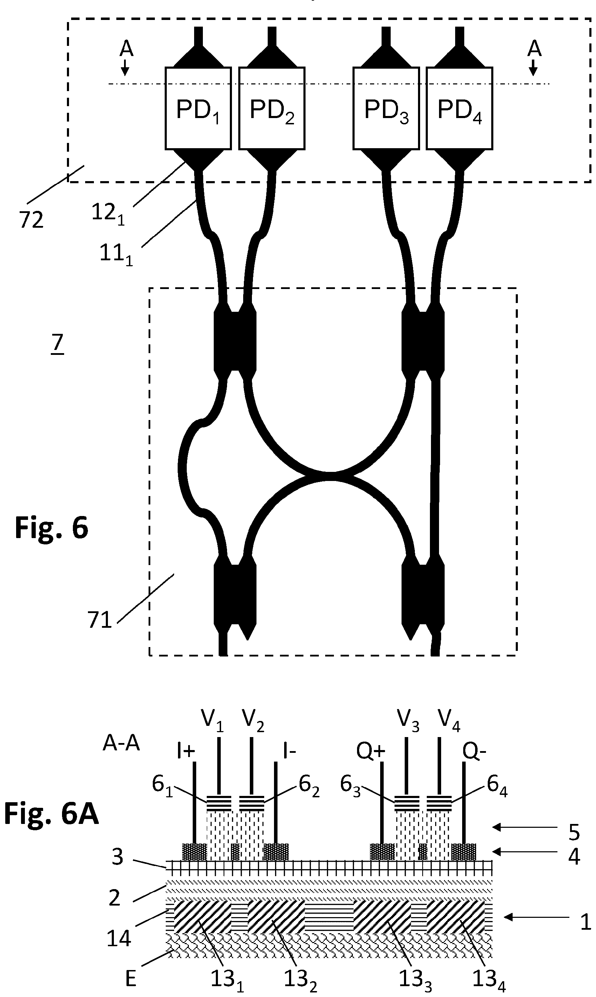

Fig. 6 schematically shows an I/Q detector 7 having arranged four photodetectors PD1, PD2, PD3, PD4 according to the present invention and a photonic hybrid 71. The photodetectors PD1, PD2, PD3, PD4 receive optical signals oS1, oS2, oS3, oS4 (not shown in Fig. 6) from the photonic hybrid 71 via narrow sections 111, 112, 113, 114. The photodetectors PD1, PD2, PD3, PD4 include widening sections 121, 122, 123, 124 for distributing optical power of the optical signals oS1, oS2, oS3, oS4.

Fig. 6A schematically shows cross-section A-A of the four photodetectors shown in Fig. 6. The photonic layer 1 includes wide sections 131, 132, 133, 134, which receive optical power from respective widening sections 121, 122, 123, 124. The spacer layer 2 is arranged on top of the photonic layer 1. The 2D material layer 3 is arranged on top of the spacer layer 2. The plasmonic layer 4 is arranged on top of the 2D material layer 3. A passivation layer 5 is arranged on top of the plasmonic layer 4. Top gate layers 61, 62, 63, 64 are arranged on top of the passivation layer 5. The plasmonic layer 4 is connected to provide signals I+, I- and Q+, Q- of the I/Q detector. The top gate layers 61, 62, 63, 64 are connected to voltages V1, V2, V3, V4.

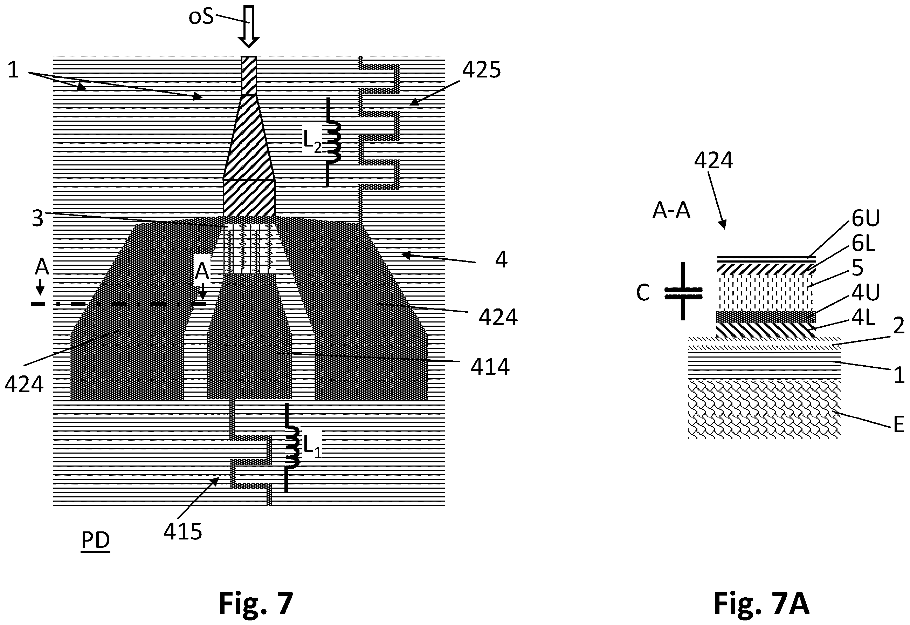

Fig. 7 schematically shows a top view of a photodetector PD according to the present invention having arranged connection lines 415, 425 implementing inductors L1, L2. Fig. 7 does not illustrate a passivation layer 5 nor a top gate layer 6. In case of a top gate layer 6, similar connection lines can be arranged to implement inductors. The connection lines 415, 425 can have different forms, such as meander, etc., to implement inductors, or be straight lines to implement electrical access without additional inductance. In some embodiment, the plasmonic layer 4 and/or the top gate layer 6 can include a spiral inductor. The connection lines 415, 425 have an electrical connection to the plasmonic resonators 411, 421.

Fig. 7A schematically shows cross-section A-A of the photodetector shown in Fig. 7 implementing a capacitor C. The top gate layer 6, the passivation layer 5 and the plasmonic layer 4, which includes the connector pad 424, form a capacitor C. In some embodiments, at the connector pad 424 the passivation layer 5 and the top gate layer 6 are missing, thereby enabling electrical access without additional capacitance.

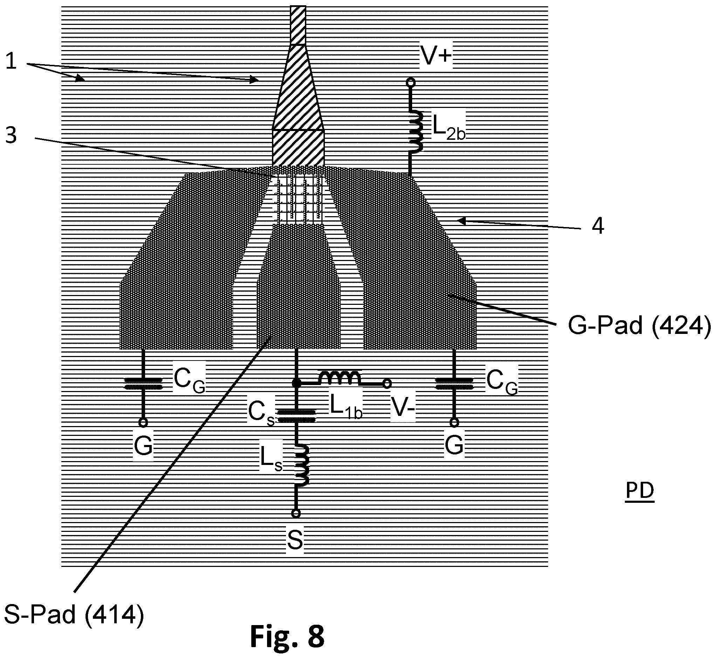

Fig. 8 schematically shows a top view of a photodetector PD according to the present invention including inductors and capacitors. Fig. 8 shows structural features of the photodetector PD as well as equivalent circuits formed by structural features according to Fig. 7, 7A. S-Pad corresponds to formerly denominated connector pad 414 and denominates signal. G-Pad corresponds to formerly denominated connector pad 424 and denominates ground. V+ and V- denominate a bias. Depending on the equivalent circuit, peaking, on-chip bias-tee, etc. can be enabled. On chip integration according to the equivalent circuit is enabled. The plasmonic layer 4 and/or the top gate layer 6 can be involved. The order of inductors and capacitors can be selected. The bias V+/V- can be applied with or without inductance.

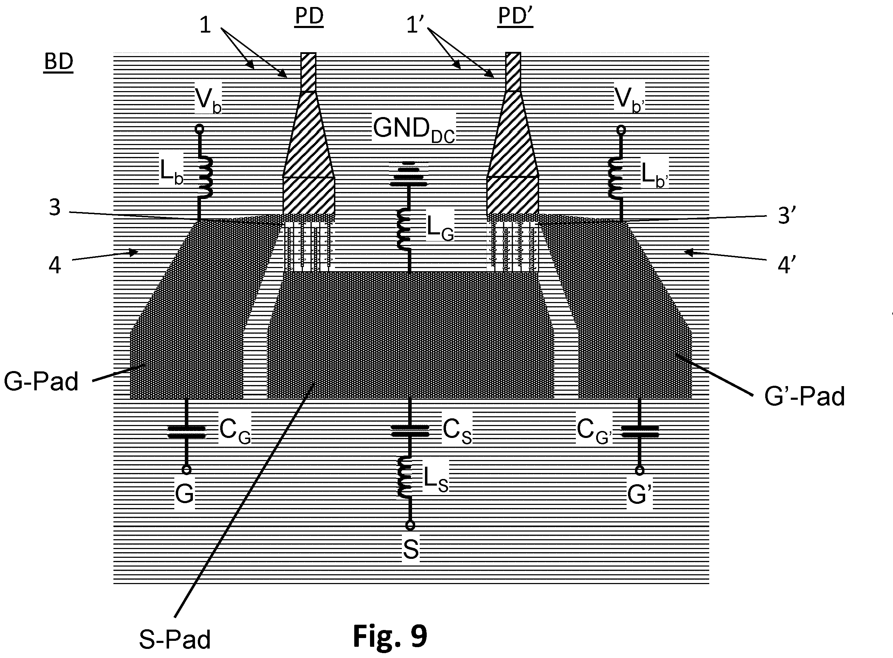

Fig. 9 schematically shows a top view of a balanced detector BD having arranged two photodetectors PD, PD' according to the present invention. A first photodetector PD includes photonic layer 1, 2D material layer 3 and plasmonic layer 4, which includes G-Pad and S-Pad. A second photodetector PD' includes photonic layer 1', 2D material layer 3' and plasmonic layer 4', which includes G'-Pad and S-Pad. S-Pad is shared between the photodetectors PD, PD'. The balanced detector BD according to Fig. 9 further includes structural features as described above for forming the equivalent circuit diagram shown in Fig. 9. The balanced detector BD can be configured with or without bias-tee. Materials of the photodetectors PD, PD' can be different in any combination. A configuration of the balanced detector BD can have removed capacitor CS shown in Fig. 9. A configuration of the balanced detector BD can have removed capacitors CG, CG' shown in Fig. 9. A configuration of the balanced detector BD can have removed GNDDC and LG shown in Fig. 9. A configuration of the balanced detector BD can have removed inductor LS shown in Fig. 9. A configuration of the balanced detector BD can have removed connection to Vb, Vb' shown in Fig. 9. A configuration of the balanced detector BD can only include inductor LS shown in Fig. 9.

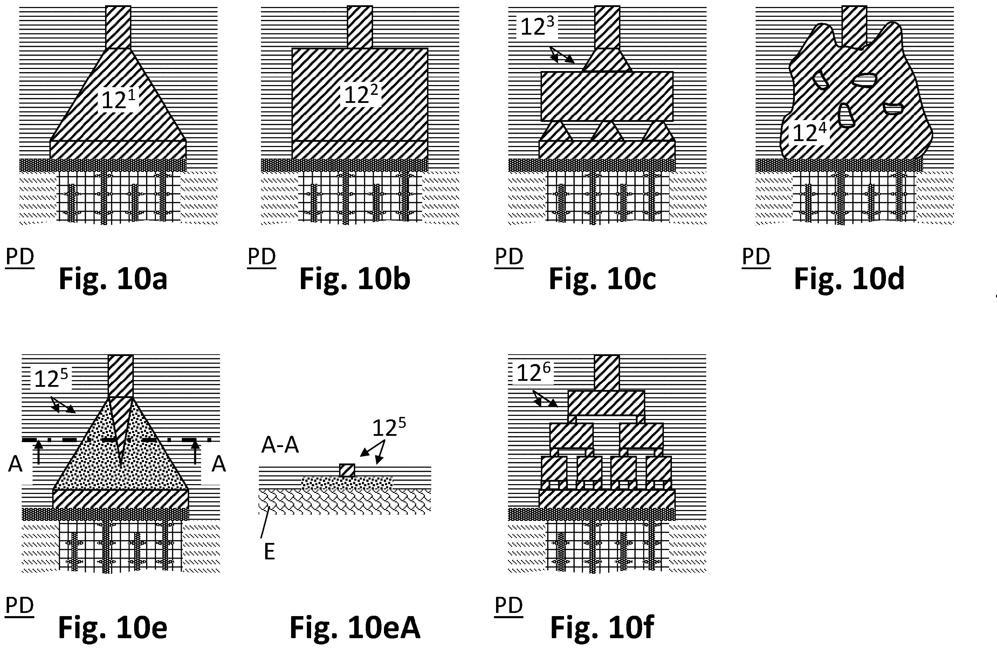

Fig. 10a-f schematically show embodiments of widening sections 12¹, 12², 12³, 12⁴, 12⁵, 12⁶ of photodetectors PD according to the present invention. The widening sections 12¹, 12², 12³, 12⁴, 12⁵, 12⁶ can include trapezoid, rectangular, multi-mode interference, star-coupler, arbitrary etched or partially etched layouts.

Fig. 10a shows a widening section 12¹ which has the form of a trapezoid, which is a simple layout.

Fig. 10b shows a widening section 12² which has the form of a rectangle, which is another simple layout. By tuning the length, the optical signal can be guided to the plasmonic layer.

Fig. 10c shows a widening section 12³ which includes a subsection having the form of a trapezoid followed by a subsection having the form of a rectangle followed by a subsection which includes three sub-subsections having the form of a trapezoid. Any number of subsections, sub-subsections, etc. and forms can be arranged.

Fig. 10d shows a widening section 12⁴ which has an arbitrary form having local cutouts. Edges may bend backwards and may have a variable number of bends towards the plasmonic layer 4. The form of may be designed according to an optimization procedure.

Fig. 10e shows a widening section 12⁵ which includes a triangle arranged above a trapezoid. The widening section 12⁵ can be at least partially reduced in height or width. Because of the lowered photonic layer, reflections from the connector lines, connector pads, etc. can be reduced.

Fig. 10e A schematically shows cross-section A-A of the photodetector shown in Fig. 10e. The widening section 12⁵ includes a first section arranged on top of a second section, wherein the first section is reduced in width with respect to the second section.

Fig. 10f shows a widening section 12⁶ which includes a tree of rectangular elements.

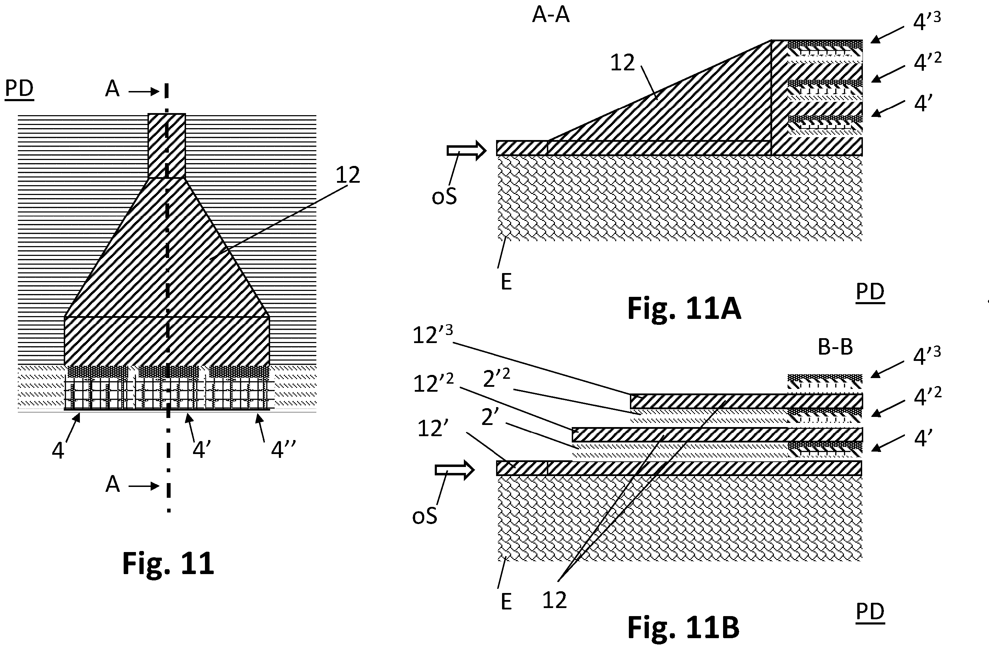

Fig. 11 schematically shows a photodetector according to the present invention having arranged a plurality of plasmonic layers in a horizontal and vertical direction. In a horizontal direction, three plasmonic layers 4, 4', 4" are arranged. Any number of horizontal plasmonic layers 4, 4', 4" can be arranged. Cross-section A-A is indicated in Fig. 11.

Fig. 11A schematically shows the cross-section A-A of the photodetector shown in Fig. 11. The widening section 12 widens as well in a vertical direction. In the vertical direction, three plasmonic layers 4', 4'2, 4'3 are arranged. Any number of vertical plasmonic layers 4', 4'2, 4'3 can be arranged.

Fig. 11B schematically shows a cross-section B-B of a photodetector PD with a plurality of plasmonic layers 4', 4'2, 4'3 in a vertical direction. The cross-section B-B has essentially the same direction as cross-section A-A shown in Fig. 11, however, Fig. 11B does not show the cross-section A-A of the photodetector PD shown in Fig. 11. A plurality of widening sections 12', 12'2, 12'3 is separated in a vertical direction by spacers 2', 2'2. The optical signal oS is directionally coupled to the upper widening sections 12'2, 12'3. Distribution in vertical direction is achieved.

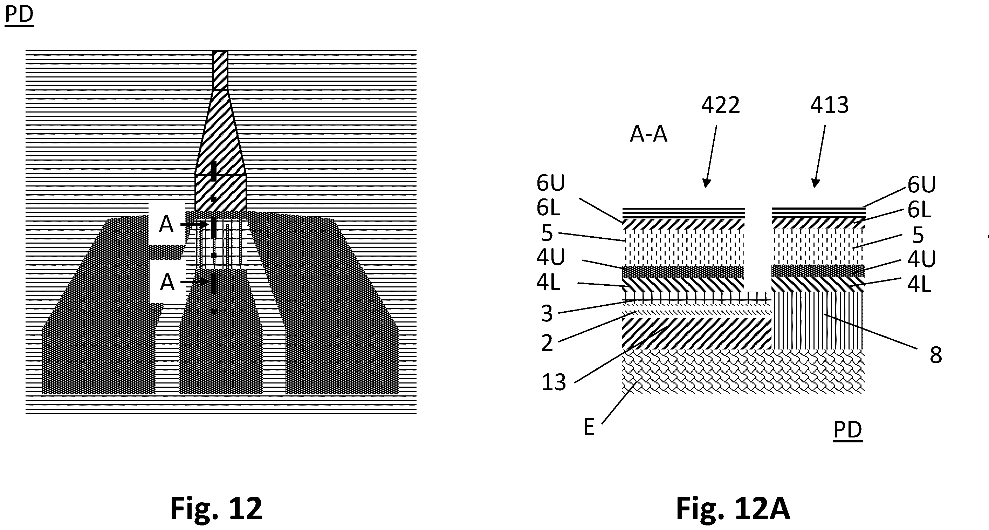

Fig. 12 schematically shows a top view of a photodetector according to the present invention. Fig. 12 corresponds to Fig. 7. The cross-section A-A indicated in Fig. 12 differs from the cross-section A-A indicated in Fig. 7. In Fig. 12, reference numerals are omitted for clarity.

Fig. 12A schematically shows the cross-section A-A of the photodetector shown in Fig. 12. The photodetector PD includes a mirror element 8. The mirror element 8 follows the wide section 13 in direction of propagation of the optical signal oS. The mirror element 8 reflects the optical signal oS back to the wide section 13.

The substrate E can include and is not limited to silicon.

The photonic layer 1 can include and is not limited to silicon, silicon nitride chalcogenide glass, germanium, plasmonic waveguides, etc.

The photonic layer 1 can be electrically contacted. The 2D material can be gated.

The spacer layer 2 can include and is not limited to aluminum oxide, hafnium oxide, silicon oxide, silicon nitride, titanium oxide, boron nitride, etc.

The 2D material layer 3 with one or more layers of a 2D material could e.g. be realized by transition metal dichalcogenide (TMDCs), semiconducting or metallic dichalcogenides, perovskite-type and many other monolayered materials. Examples of which are e.g. PtSe2 platinum diselenide, PdSe2 palladium diselenide, MoTe2 molybdenum ditelluride, MoS2, WSe2, etc. Likewise, it could be realized by any of the following materials such as graphene, rotationally stacked graphene, graphene nanoribbons. Further, it could be realized by a stacking a combination of all of the above forming so-called Vand der Waals heterostructures, etc. For example, the 2D material layer 3 can absorb infrared light.

The 2D material layer 3 can have various thicknesses and can include mono-, bi-, tri-layer, etc. designs. For example, performance of the photodetector PD depends on the thickness.

The 2D material layer 3 can include on one or both sides a 2D material insulator which can e.g. include and is not limited to hexagonal boron nitride (hBN).

The 2D material layer 3 can be designed as a Vand der Waals heterostructure stack to change properties. For example, hexagonal boron nitride (hBN) can be included to improve characteristics of the 2D material, such as graphene. Materials such as molybdenum disulfide (MoS2) can provide a contact material to achieve diode-like behavior.

Layer materials and thicknesses beyond the 2D material can be changed for the purpose of optimization.

The plasmonic layer 4 can include and is not limited to semiconductor, semi-metallic and conductive materials such as gold, silver, aluminum, copper, palladium, tungsten, platinum, titanium, chromium, nickel, etc.

The contact lines 412, 422 can include and are not limited to gold, silver, aluminum, copper, palladium, tungsten, platinum, titanium, chromium, nickel, etc.

The plasmonic resonators 411, 421 can include and are not limited to gold, silver, aluminum, copper, palladium, tungsten, platinum, titanium, chromium, nickel, etc.

The shape of these plasmonic resonators 411, 421 may include but is not limited to dipole antenna, bow-tie antenna, leaf clover, patch antenna, etc.

The lower plasmonic layer 4L and/or the upper plasmonic layer 4U can include and is not limited to gold, silver, etc. The lower plasmonic layer 4L and the upper plasmonic layer 4U of different contact lines 412, 422 can include alternating materials.

The lower plasmonic layer 4L and/or the upper plasmonic layer 4U can enable n- and p-type contact doping. For example, by alternating the materials of the plasmonic resonators 411, 421 of the lower plasmonic layer 4L (e.g. Au and Ag), a 2D material channel of the 2D material layer 3 can be doped with a p-n profile.

The passivation layer 5 can include and is not limited to aluminum oxide, hafnium oxide, silicon oxide, silicon nitride, titanium oxide, boron nitride, etc.

The top gate layer 6 can include and is not limited to gold, silver, graphene, etc. The top gate layer 6 can be structured to act as local gate. Several gates can be realized within the top gate layer 6 which can be individually or combined addressed leading to several local gates.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

**LIST OF REFERENCE SIGNS**

| | | | |
|---|---|---|---|
| PD | photodetector | oS | optical signal |
| E | substrate | | |
| 1 | photonic layer | 11 | narrow section |
| 12; 12¹, 12², 12³, 12⁴, 12⁵, 12⁶ | widening section | | |
| 13 | wide section | 14 | photonic cladding |
| 2 | spacer layer | 3 | 2D material layer |
| 4 | plasmonic layer | | |
| 4L | lower plasmonic layer | 4U | upper plasmonic layer |
| 41 | first plasmonic structure | 411 | first plasmonic resonators |
| 412 | first contact lines | 413 | first connector line |
| 414 | first connector pad | | |
| 42 | second plasmonic structure | 421 | second plasmonic resonators |
| 422 | first contact lines | 423 | second connector line |
| 424 | second connector pad | | |
| 5 | passivation layer | 6 | top gate layer |
| 7 | I/Q detector | | |
| 71 | photonic hybrid | 72 | one or more photodetectors |
| 8 | mirror element | | |

## Claims

1. A photodetector (PD), comprising:
a photonic layer (1) which includes a widening section (12) followed by a wide section (13), wherein the widening section (12) is configured to receive an optical signal (oS) and to distribute optical power of the optical signal (oS) to the wide section (13),
a 2D material layer (3) which is arranged between the wide section (13) and
a plasmonic layer (4) which is in contact with the 2D material layer (3) and includes a plurality of plasmonic resonators (411, 421) which are connected via contact lines (412, 422) to connector lines (413, 423), wherein the connector lines (413, 423) enable to measure charge carriers which are generated upon receipt of the optical signal (oS).

2. The photodetector (PD) according to claim 1, wherein a spacer layer (2) is in contact with the wide section (13) and the 2D material layer (3).

3. The photodetector (PD) according to claim 1 or 2, wherein one or more of the plasmonic resonators (411, 421), the contact lines (412, 422) and the connector lines (413, 423) include a lower layer (4L) which is in contact with the 2D material layer (3) and an upper layer (4U) which is in contact with the lower layer (4L), wherein a material of the lower layer (4L) differs from a material of the upper layer (4U).

4. The photodetector (PD) according to one of claims 1 to 3, wherein the plasmonic resonators (412, 422) and/or the contact lines (412, 422) have an alternating configuration.

5. The photodetector (PD) according to one of claims 1 to 4, wherein the 2D material layer (3) includes a 2D material selected from one or more of a graphene, a semiconducting material, a Vand Der Waals heterostructure material, and a semimetal material.

6. The photodetector (PD) according to one of claims 1 to 5, wherein the plasmonic layer (4) is in contact with a passivation layer (5).

7. The photodetector (PD) according to claim 6, wherein the passivation layer (5) is in contact with a top gate layer (6).

8. The photodetector (PD) according to one of claims 1 to 7, wherein a mirror element (8) is arranged which follows the wide section (13) and which is configured to reflect optical power back to the wide section (13).

9. The photodetector (PD) according to one of claims 1 to 8, wherein the plasmonic resonators (411, 421) include elements which have different geometries.

10. The photodetector (PD) according to one of claims 1 to 9, wherein the widening section (12; 12¹, 12², 12³, 12⁴, 12⁵, 12⁶) is formed by one or more elements having the form of one or more of a trapezoid, a rectangle, and an arbitrary form.

11. The photodetector (PD) according to one of claims 1 to 10, further including one or more inductive elements (415, 425) which are connected with the connector lines (413, 423).

12. The photodetector (PD) according to one of claims 1 to 11, further including a bias tee.

13. Two photodetectors (PD, PD') according to one of claims 1 to 12 connected to a common connector pad (S-Pad).

14. An apparatus comprising one or more photodetectors (PD1, PD2; PD1, PD2, PD3, PD4) according to one of claims 1 to 12.

15. The apparatus according to claim 14, configured to provide an I/Q detector (7) or a balanced detector (BD).
